# EUROPÄISCHE PATENTSCHRIFT

(11) **EP 0 827 277 B1**
(45) Veröffentlichungstag und Bekanntmachung des Hinweises auf die Patenterteilung: **14.05.2003**
(21) Anmeldenummer: 97402009.1
(22) Anmeldetag: 27.08.1997
(51) Int. Cl.: H03J 7/04

(54) **Funkfeststation mit abstimmbarem Oszillator und Verfahren zum Abstimmen des Oszillators**
Base station with tuneable oscillator and method for tuning of this oscillator
Station de base avec circuit oscillateur accordable et procédé d'accord de cet oscillateur

(30) Priorität: 28.08.1996 DE 19634740
(43) Veröffentlichungstag der Anmeldung: 04.03.1998
(73) Patentinhaber: ALCATEL, 75008 Paris (FR)
(72) Erfinder: Wolf, Michael, Dr., 74395 Mundelsheim (DE)
(74) Vertreter: Schätzle, Albin, Dipl.-Phys.

(56) Entgegenhaltungen:
- EP-A- 0 123 587
- WO-A-96/19875
- US-A- 5 392 005

## Beschreibung

Die Erfindung betrifft eine Funkfeststation mit abstimmbarem Oszillator gemäß dem Oberbegriff des Patentanspruchs 1 und ein Verfahren zum Abstimmen eines abstimmbaren Oszillators gemäß dem Oberbegriff des Patentanspruchs 7.

In Funkfeststationen für Mobilfunknetze, welche beispielsweise nach dem GSM-Standard arbeiten, werden hochstabile Oszillatoren zur Erzeugung einer Trägerfrequenz benötigt. Der relative Frequenzfehler solcher Oszillatoren muß kleiner als 5•10⁻⁸ sein, um den GSM-Standard zu erfüllen (GSM 11.21). Quarzoszillatoren, die zur Zeit eingesetzt werden, sind kostengünstig, erfüllen diese Anforderungen aber nur mangelhaft, da sie aufgrund von Alterung eine Frequenzdrift aufweisen. Solche Quarzoszillatoren müssen daher regelmäßig abgestimmt werden, wobei manuelles Abstimmen der Oszillatoren wegen der weit verstreuten Aufstellung von Funkfeststationen sehr aufwendig ist.

In einem Aufsatz von O. Leibfried, Kompakte temperaturstabilisierte Quarzoszillatoren (OCXO) mit interner DCF-77 Synchronisation, abgedruckt in dem Buch Funkuhrtechnik, Editor W. von Hilbert, Verlag Oldenbourg 1993, ist ein Quarzoszillator zum Einsatz in Funkfeststationen beschrieben, der zum Ausgleich von alterungsbedingter Frequenzdrift durch eine Vorrichtung zum Abgleichen des Oszillators auf die Normalfrequenzaussendung von DCF-77 synchronisiert wird. Die Langzeitstabilität der Frequenz bei der vorgestellten Lösung ist 10⁻⁹. Allerdings ist die vorgestellte Lösung sehr aufwendig, da in der Vorrichtung zum Abgleichen des Oszillators neben einer Empfangseinrichtung mit externer Antenne eine analoge Filerschaltung, ein Hilfsoszillator und ein Mikroprozessor benötigt werden. Daneben ist die Lösung anfällig gegen langanhaltende Störungen des DCF-77 Trägers.

Aus der Patentschrift US 5.392.005 ist eine Schaltungsanordnung mit einem Quarzoszillator bekannt, welche die Frequenz des Oszillators mit einer externen Referenzfrequenz vergleicht und bei Abweichung der Frequenz des Oszillators diesen mit einem aus der Differenz zu der Referenzfrequenz berechneten Korrektursignal abgleicht. Die Schrift erwähnt auch einen Detektor, der die Stabilität der externen Referenzfrequenz überwachen soll, ohne jedoch Hinweise auf die Ausführung dieses Detektors zu geben. Desweiteren erwähnt die Schrift, daß die Schaltungsanordnung in einer Fernmeldevermittlungsstelle eingesetzt wird und die externe Referenzfrequenz von einem Fernmeldenetz abgeleitet ist, mit welchem die Fernmeldevermittlungsstelle verbunden ist. Das Dokument WO96/19875 beschreibt einen in ähnlicher Weise funktionierenden kontinuierlichen Frequenzabgleich.

Eine Aufgabe der Erfindung ist es, eine Funkfeststation mit einem abstimmbaren Oszillator anzugeben, bei der mit geringem technischen Aufwand eine hohe Langzeitstabilität des Oszillators entsprechend dem GSM-Standard erreicht wird. Eine weitere Aufgabe der Erfindung ist es, ein Verfahren zum Abstimmen eines abstimmbaren Oszillators in einer Funkfeststation anzugeben, mit welchem eine Frequenzdrift des Oszillators ausgeglichen wird, ohne daß sich eventuelle Störungen einer externen Referenzfrequenz auf die Frequenzgenauigkeit des Oszillators auswirken.

Die Aufgabe wird betreffend der Funkfeststation durch die Merkmale des Patentanspruchs 1 und betreffend des Verfahrens durch die Merkmale des Patentanspruchs 7 gelöst. Vorteilhafte Ausgestaltungen sind den abhängigen Patentansprüchen zu entnehmen.

Ein Vorteil der Erfindung besteht darin, daß in einer Funkfeststation kostengünstige Oszillatoren eingesetzt werden können, da die Anforderung an die Langzeitstabilität des Oszillators durch häufiges Abstimmen entfällt. Dennoch wird mit der Erfindung eine höhere Langzeitstabilität des Oszillators erreicht, als dies bei bisher verwendeten frei laufenden Oszillatoren der Fall war, da der Oszillator mit einer hochgenauen (10⁻¹¹) Referenzfrequenz abgestimmt wird.

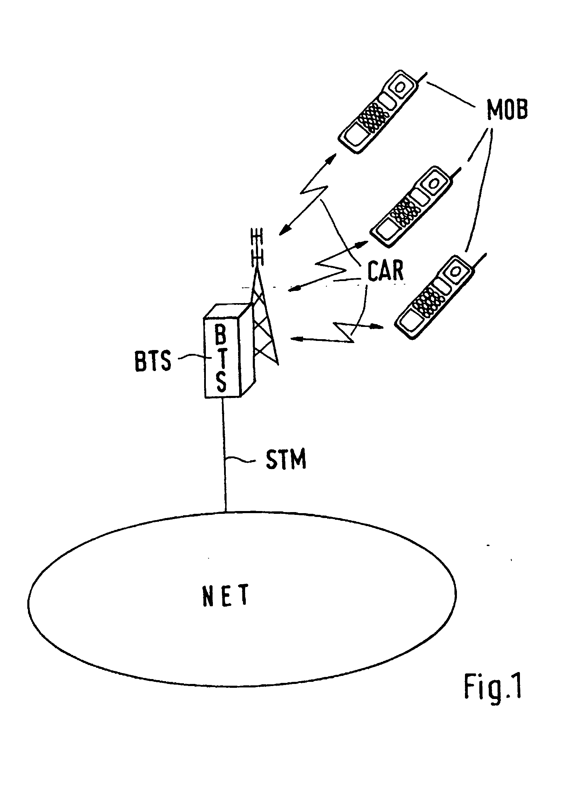

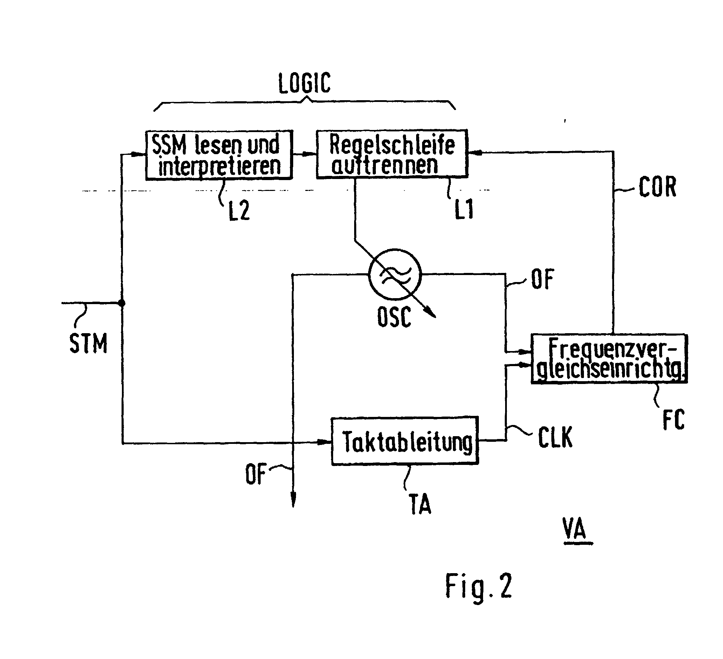

Im folgenden wird ein Ausführungsbeispiel der Erfindung anhand der Figuren 1 und 2 beschrieben. Es zeigen:
- Figur 1: eine Funkfeststation, welche an ein digitales Nachrichtenübertragungsnetz angeschlossen ist und in Funkverbindung zu Mobilfunkgeräten steht und
- Figur 2: ein Blockschaltbild einer Vorrichtung zum Abstimmen eines abstimmbaren Oszillators.

Eine Grundidee der Erfindung liegt darin, zum Abstimmen eines in einer Funkfeststation enthaltenen Oszillators eine externe Referenzfrequenz zu verwenden, welche in der Funkfeststation verfügbar ist. Eine solche externe Referenfrequenz ist die Pulsfolgefrequenz eines digitalen Nachrichtensignales, das von der Funkfeststation aus einem digitalen Nachrichtenübertragungsnetz empfangen wird, an welches die Funkfeststation angeschlossen ist. Die Pulsfolgefrequenz weist jedoch Frequenzschwankungen auf, wenn in dem digitalen Nachrichtenübertragungsnetz Synchronisationsstörungen auftreten.

Damit Synchronisationsstörungen in dem digitalen Nachrichtenübertragungsnetz sich nicht auf die Frequenzgenauigkeit des Oszillators auswirken, wird ein Qualitätsindikator, der in dem digitalen Nachrichtensignal enthalten ist und die Frequenzgenauigkeit der Pulsfolgefrequenz angibt, gelesen und der Oszillator wird nur zu Zeiten abgestimmt, in denen der Qualitätsindikator eine hohe Frequenzgenauigkeit der Pulsfolgefrequenz garantiert. Ein solcher Qualitätsindikator ist in den ITU-T-Empfehlungen G.70X für digitale Nachrichtensignale der synchronen digitalen Hierarchie (SDH) und in G.704 für digitale Nachrichtensignale der plesiochronen digitalen Hierarchie (PDH) definiert. Die hohe Frequenzgenauigkeit der Pulsfolgefrequenz, die der Qualitätsindikator garantieren kann, ist nach der ITU-T Empfehlung G.811 10⁻¹¹, d.h. der relative Frequenzfehler ist kleiner oder gleich 10⁻¹¹.

In Figur 1 ist eine Funkfeststation BTS dargestellt. Sie ist angeschlossen an ein digitales Nachrichtenübertragungsnetz NET, welches entweder den Anforderungen der synchronen digitalen Hierarchie (SDH) oder denen der plesiochronen digitalen Hierarchie (PDH) entsprechen kann. Von dem digitalen Nachrichtenübertragungsnetz NET empfängt die Funkfeststation BTS ein digitales Nachrichtensignal STM. Zudem sind beispielhaft drei Mobilfunkgeräte MOB gezeigt, welche in Funkverbindung zu der Funkfeststation BTS stehen. Zur Funkübertragung zwischen Funkfeststation BTS und Mobilfunkgerät MOB wird eine Trägerfrequenz CAR genutzt.

Zur Erzeugung der Trägerfrequenz CAR enthält die Funkfeststation BTS einen Oszillator, der eine relative Frequenzgenauigkeit von besser als 5•10⁻⁸ haben muß, um den GSM-Standard 11.21 zu erfüllen. Um langsame Frequenzdrifts des Oszillators, z.B. durch Alterung, ausgleichen zu können, besitzt die Funkfeststation zusätzlich eine Vorrichtung zum Abstimmen des Oszillators.

In Figur 2 ist in einem Ausführungsbeispiel eine Vorrichtung VA zum Abstimmen des Oszillators in einem Blockschaltbild dargestellt. Sie besteht aus einer Taktableitungseinrichtung TA, einer Frequenzvergleichseinrichtung FC, einer Steuerungseinrichtung LOGIC und dem abstimmbaren Oszillator OSC. Die Taktableitungseinrichtung TA hat einen Eingang an welchem das digitale Nachrichtensignal STM anliegt und einen Ausgang, der den aus dem digitalen Nachrichtensignal STM abgeleiteten Takt CLK liefert. Der abgeleitete Takt CLK hat eine Pulsfolgefrequenz, die als externe Referenzfrequenz zum Abgleichen des Oszillators OSC dient.

Die Frequenzvergleichseinrichtung FC besitzt zwei Eingänge. Der eine Eingang ist mit dem Ausgang der Taktableitungseinrichtung TA verbunden, der zweite Eingang mit einem Frequenzausgang des Oszillators OSC. An den Eingängen der Frequenzvergleichseinrichtung FC liegen also die Frequenzsignale CLK, OF von Taktableitungseinrichtung TA und Oszillator OSC an. Die Frequenzvergleichseinrichtung FC vergleicht die beiden Frequenzsignale CLK, OF und generiert ein Korrektursignal COR, das von einer Differenz zwischen der Frequenz OF des Oszillators OSC und der Pulsfolgefrequenz CLK abhängig ist. An einem Ausgang der Frequenzvergleichseinrichtung FC ist dieses Korrektursignal COR abgreifbar.

In der Vorrichtung VA zum Abstimmen des Oszillators OSC kann auch noch ein Teiler enthalten sein, der die Referenzfrequenz CLK oder die Frequenz OF des Oszillators teilt. Dies kann notwendig sein, um die beiden Frequenzen OF, CLK nominell aneinander anzugleichen. So kann es sich bei dem Takt CLK des digitalen Nachrichtensignales STM beispielsweise um den 2 MHz Takt eines STM-1 Signales der synchronen digitalen Hierarchie handeln. Soll mit diesem Signal ein 10 MHz Oszillator abgestimmt werden, so wird die Frequenz OF des Oszillators OSC mit einem Teiler durch 5 geteilt und anschließend mit der Referenzfrequenz CLK verglichen. Weichen die nominell gleichen Frequenzen OF und CLK voneinander ab, so muß der Oszillator OSC abgestimmt werden, sobald der Qualitätsindikator eine Frequenzgenauigkeit angibt, die höher als die für den Oszillator geforderte Frequenzgenauigkeit ist.

Der Ausgang der Frequenzvergleichseinrichtung FC ist mit der Steuerungseinrichtung LOGIC verbunden. Die Steuerungseinrichtung LOGIC weist einen Eingang auf, an dem ebenfalls das digitale Nachrichtensignal STM anliegt. Aufgabe der Steuerungseinrichtung LOGIC ist es, einen Qualitätsindikator zu lesen, der in dem digitalen Nachrichtensignal enthalten ist, und in Abhängigkeit des Qualitätsindikators den Oszillator OSC mit dem Korrektursignal COR anzustimmen.

Als Qualitätsindikator dient vorzugsweise ein vorbestimmtes Bit oder eine vorbestimmte Bitfolge in dem Rahmen der empfangenen digitalen Nachrichtensignale. Das Nachrichtensignal ist vorzugsweise ein pulskodemoduliertes Nachrichtensignal, z.B. PCM-30, das von einer Mobilvermittlungsstelle (MCS, mobile switching center) empangen wird, an die die Funkfeststation über das Nachrichtenübertragungsnetz angeschlossen ist.

Bei dem digitalen Nachrichtensignal STM kann es sich um ein Nachrichtensignal der synchronen digitalen Hierarchie (SDH) oder um ein Nachrichtensignal der plesiochronen digitale Hierarchie (PDH) handeln. In beiden Fällen weist das Nachrichtensignal STM Rahmen auf, in welchen der Qualitätsindikator enthalten ist. Der Qualitätsindikator gibt die Synchronisationsqualität des sendenden Netzelementes an, von dem die Funkfeststation das Nachrichtensignal STM empfängt, und damit die Frequenzgenauigkeit des Taktes CLK. Bei einem Nachrichtensignal der synchronen digitalen Hierarchie (SDH) besteht der Qualitätsindikator aus den Bits 5 bis 8 des S1-Bytes, das in dem sogenannten Section Overhead (SOH) der Rahmen von dem Nachrichtensignal enthalten ist. Bei Nachrichtensignalen der plesiochronen digitalen Hierarchie (PDH) handelt es sich bei dem Qualitätsindikator um eines der Bits Sₐ₄ bis Sₐ₈, das in der Überrahmenstruktur des Nachrichtensignales STM enthalten ist (ITU-T G.704).

Besteht der Qualitätsindikator aus der Bitfolge 0010, so ist für den Takt des digitalen Nachrichtensignales die höchste Frequenzgenauigkeit garantiert. Nach der ITU-T-Empfehlung G.811 bedeutet dies eine relative Frequenzabweichung von maximal 10⁻¹¹. Die Steuerungseinrichtung LOGIC stimmt daher in Zeiten, in denen der Qualitätsindikator aus der Bitfolge 0010 besteht, den Oszillotor OSC mit dem Korrektursignal COR ab.

Treten in dem digitalen Nachrichtenübertragungsnetz NET Synchronisationsstörungen auf, z.B. durch Ausfall einer Übertragungsstrecke oder eines Netzelementes, so dürfen sich diese Störungen nicht auf die Frequenzgenauigkeit der Trägerfrequenz der Funkfeststation auswirken. Dies wird erreicht, indem insbesondere in Zeiten in denen der Qualitätsindikator aus der Bitfolge 0000, 1111 oder 1011 besteht, der Oszillator OSC nicht mit dem Korrektursignal COR abgestimmt wird. Die Bitfolge 1111 und 0000 bedeutet, daß die Synchronisationsqualität unbekannt ist und die Bitfolge 1011 zeigt an, daß der Taktgenerator des sendenden Netzelementes nicht synchronisiert ist. Die Bitfolgen 0010 und 1000 bedeuten eine weniger hohe Frequenzgenauigkeit des Taktes, alle anderen möglichen Bitfolgen sind in den Standards nicht festgelegt. Der Oszillator OSC wird daher vorzugsweise nur in den Zeiten abgestimmt, in denen der Qualitätsindikator die Bitfolge 0010 enthält.

In dem Ausführungsbeispiel besteht die Steuerungseinrichtung LOGIC aus einer ersten Baugruppe L1, die zum Abstimmen das Korrektursignal COR der Frequenzvergleichseinrichtung FC zu dem Oszillator OSC weiterleitet und die Regelschleife zwischen Oszillator OSC, Frequenzvergleichseinrichtung FC und Steuerungseinrichtung LOGIC schließt oder auftrennt, und aus einer zweiten Baugruppe L2, die den Qualitätsindikator liest und die erste Baugruppe L1 umschaltet.

Der Oszillator OSC hat im Ausführungsbeispiele zwei Frequenzausgänge. Der eine ist mit einem Eingang der Frequenzvergleichseinrichtung FC verbunden und am anderen ist das Frequenzsignal OF zur Erzeugung der Trägerfrequenz abgreifbar. Es kann sich bei dem Oszillator um einen temperaturstabilisierten Quarzoszillator (Oven Controled Quarz Oscillator, OCXO) handeln oder auch um einen Quarzoszillator mit digitaler Temperaturkompensation (Digital Temperature Controled Quarz Oscillator, DTCXO). Es können jedoch auch einfache Quarzoszillatoren ohne Temperaturregelung oder -kompensation eingesetzt werden, da auch temperaturbedingte Frequenzdrifts des Oszillators durch häufiges Abstimmen mit der Pulsfolgefrequenz aus dem digitalen Nachrichtenübertragungsnetz ausgeglichen werden.

Das Abstimmen des Quarzoszillators kann durch Lastkapazitäten erfolgen, die in Serie mit dem Quarzoszillator geschaltet sind. Als Lastkapazitäten können beispielsweise Kapazitätsdioden oder Kombinationen von Kapazitätsdioden mit Kondensatoren verwendet werden. Die Kapazität der Kapazitätsdioden kann dann durch Anlegen einer Korrekturspannung eingestellt werden. In diesem Fall ist das von der Frequenzvergleichseinrichtung FC generierte Korrektursignal COR eine Korrekturspannung, welche zum Abstimmen des Oszillators OSC von der Steuerungseinrichtung LOGIC auf die Kapazitätsdioden des Oszillators OSC geschaltet wird.

Bei einer besonders vorteilhaften Ausgestaltung der Erfindung enthält die Frequenzvergleichseinrichtung FC einen Tiefpaß, der Phasen- und Frequenzschwankungen des Taktes CLK mit einer Zeitkonstante von bis zu mehreren Stunden unterdrückt. Dies bewirkt, daß kurzfristige Frequenzschwankungen des Taktes CLK sich nicht über ein Abstimmen des Oszillators OSC auf die Trägerfrequenz CAR der Funkfeststation BTS auswirken.

## Patentansprüche

1. Funkfeststation (BTS) mit einem abstimmbaren Oszillator (OSC) zur Erzeugung einer Trägerfrequenz (CAR) und einer Vorrichtung (VA) zum Abstimmen des Oszillators (OSC), **dadurch gekennzeichnet, daß** die Vorrichtung (VA) zum Abstimmen des Oszillators (OSC) folgende Funktionseinheiten enthält:
- eine Taktableitungseinrichtung (TA) zum Erzeugen eines Taktes (CLK) mit einer Pulsfolgefrequenz aus einem digitalen Nachrichtensignal (STM),
- einer Frequenzvergleichseinrichtung (FC) zum Generieren eines von einer Differenz zwischen der Frequenz (OF) des Oszillators (OSC) und der Pulsfolgefrequenz des Taktes (CLK) abhängigen Korrektursignales (COR), mit dem der Oszillator (OSC) abstimmbar ist, und
- einer Steuerungseinrichtung (LOGIC) zum Abstimmen des Oszillators (OSC) mit dem Korrektursignal (COR) in Abhängigkeit eines Qualitätsindikators, der die Stabilität des Taktes angibt und Teil des digitalen Nachrichtensignales (STM) ist,
wobei der Oszillator nur zu Zeiten abgestimmt wird, in denen der Qualitätsindikator eine hohe Frequenzgenauigkeit der Pulsfolgefrequenz garantiert.

2. Funkfeststation (BTS) gemäß Anspruch 1, **dadurch gekennzeichnet, daß** die Steuerungseinrichtung (LOGIC) zum Auswerten des Qualitätsindikators vorgesehen ist, der in dem Rahmen des empfangenen Nachrichtensignales enthalten ist.

3. Funkfeststation (BTS) gemäß Anspruch 1, **dadurch gekennzeichnet, daß** es sich bei dem Nachrichtensignal um ein pulskodemoduliertes (PCM) Nachrichtensignal handelt, welches von einer Mobilvermittlungsstelle des Nachrichtenübertragungsnetzes empfangen wird.

4. Funkfeststation (BTS) gemäß Anspruch 1, **dadurch gekennzeichnet, daß** die Taktableitungseinrichtung (TA) zum Erzeugen eines Taktes aus einem Nachrichtensignal (STM) der synchronen digitalen Hierarchie dient, daß die Steuerungseinrichtung (LOGIC) zum Abstimmen des Oszillators (OSC) als Qualitätsindikator die Bits 5 bis 8 des S1-Bytes verwendet, welches im SOH-Abschnitt des Rahmens von dem Nachrichtensignal (STM) enthalten ist, und daß der Oszillator (OSC) nur dann abstimmbar ist, wenn der Qualitätsindikator aus der Bitfolge 0010 besteht.

5. Funkfeststation gemäß Anspruch 1, **dadurch gekennzeichnet, daß** die Taktableitungseinrichtung (TA) zum Erzeugen eines Taktes aus einem Nachrichtensignal (STM) der plesiochronen digitalen Hierarchie dient, daß die Steuerungseinrichtung (LOGIC) zum Abstimmen des Oszillators (OSC) als Qualitätsindikator eines der Bits Sₐ₄ bis Sₐ₈ in der Überrahmenstruktur des Nachrichtensignales (STM) verwendet, und daß der Oszillator (OSC) nur dann abstimmbar ist, wenn der Qualitätsindikator aus der Bitfolge 0010 besteht.

6. Funkfeststation gemäß Anspruch 1, **dadurch gekennzeichnet, daß** die Taktableitungseinrichtung (TA) einen Tiefpaß enthält, der Phasen- und Frequenzschwankungen des Taktes (CLK) des digitalen Nachrichtensignales (STM) unterdrückt mit einer Zeitkonstante bis zu mehreren Stunden.

7. Verfahren zum Abstimmen eines abstimmbaren Oszillators (OSC), der zur Erzeugung einer Trägerfrequenz (CAR) einer Funkfeststation (BTS) vorgesehenen ist, **dadurch gekennzeichnet, daß** es folgende Schritte enthält:
- Erzeugen eines Taktes (CLK) mit einer Pulsfolgefrequenz aus einem digitalen Nachrichtensignal (STM),
- Generieren eines von einer Differenz zwischen der Frequenz (OF) des Oszillators (OSC) und der Pulsfolgefrequenz des Taktes (CLK) abhängigen Korrektursignales (COR),
- Abstimmen des Oszillators (OSC) mit dem Korrektursignal (COR), in Abhängigkeit eines Qualitätsindikators, der die Stabilität des Taktes angibt und Teil des digitalen Nachrichtensignales (STM) ist,
wobei der Oszillator nur zu Zeiten abgestimmt wird, in denen der Qualitätsindikator eine hohe Frequenzgenauigkeit der Pulsfolgefrequenz garantiert.

8. Verfahren gemäß Anspruch 7, **dadurch gekennzeichnet, daß** es sich bei dem digitalen Nachrichtensignal (STM) um ein Nachrichtensignal der synchronen digitalen Hierarchie handelt, daß sich der Qualitätsindikator aus den Bits 5 bis 8 des S1-Bytes zusammensetzt, welches im SOH-Abschnitt des Rahmens von dem Nachrichtensignal (STM) enthalten ist, und daß das Abstimmen des Oszillators (OSC) nur zu Zeiten erfolgt, in denen der Qualitätsindikator aus der Bitfolge 0010 besteht.

9. Verfahren gemäß Anspruch 7, **dadurch gekennzeichnet, daß** es sich bei dem digitalen Nachrichtensignal (STM) um ein Nachrichtensignal der plesiochronen digitalen Hierarchie handelt, daß als Qualitätsindikator eines der Bits Sₐ₄ bis Sₐ₈ in der Überrahmenstruktur des Nachrichtensignales (STM) verwendet und daß das Abstimmen des Oszillators (OSC) nur zu Zeiten erfolgt, in denen der Qualitätsindikator aus der Bitfolge 0010 besteht.

## Claims

1. Radio base station (BTS) with a tunable oscillator (OSC) for generating a carrier frequency (CAR) and a device (VA) for tuning the oscillator (OSC), **characterized in that** the device (VA) for tuning the oscillator (OSC) includes the following functional units:
- a timing extraction facility (TA) for generating a timing signal (CLK) with a pulse train frequency from a digital information signal (STM),
- a frequency comparison facility (FC) for generating a correction signal (COR) dependent on a difference between the frequency (OF) of the oscillator (OSC) and the pulse train frequency of the timing signal (CLK), with which correction signal the oscillator (OSC) is tunable, and
- a control facility (LOGIC) for tuning the oscillator (OSC) with the correction signal (COR), dependent on a quality indicator, which gives the stability of the timing signal and is part of the digital information signal (STM),
the oscillator only being tuned at times when the quality indicator guarantees a high frequency accuracy of the pulse train frequency.

2. Radio base station (BTS) as claimed in Claim 1, **characterized in that** the control facility (LOGIC) is provided for evaluating the quality indicator, which is included in the frame of the received information signal.

3. Radio base station (BTS) as claimed in Claim 1, **characterized in that** the information signal is a pulse code modulated (PCM) information signal, which is received from a mobile switching center of the communication network.

4. Radio base station (BTS) as claimed in Claim 1, **characterized in that** the timing extraction facility (TA) serves for generating a timing signal from an information signal (STM) of the synchronous digital hierarchy, that the control facility (LOGIC) uses, as quality indicator for tuning the oscillator (OSC), bits 5 to 8 of the S1 byte, which is contained in the SOH section of the frame of the information signal (STM); and that the oscillator (OSC) is only tunable when the quality indicator consists of the bit sequence 0010.

5. Radio base station as claimed in Claim 1, **characterized in that** the timing extraction facility (TA) serves for generating a timing signal from an information signal (STM) of the plesiochronous digital hierarchy, that the control facility (LOGIC) uses one of the bits Sₐ₄ to Sₐ₈ in the superframe structure of the information signal (STM), as quality indicator for tuning the oscillator (OSC); and that the oscillator (OSC) is only tunable when the quality indicator consists of the bit sequence 0010.

6. Radio base station as claimed in Claim 1, **characterized in that** the timing extraction facility (TA) includes a lowpass, which suppresses phase and frequency fluctuations of the timing signal (CLK) of the digital information signal (STM) with a time constant of up to several hours.

7. Method for tuning a tunable oscillator (OSC), which is provided for generating a carrier frequency (CAR) of a radio base station (BTS), **characterized in that** it contains the following steps:
- Generation of a timing signal (CLK) with a pulse train frequency from a digital information signal (STM),
- Generation of a correction signal (COR) dependent on a difference between the frequency (OF) of the oscillator (OSC) and the pulse train frequency of the timing signal (CLK),
- Tuning of the oscillator (OSC) with the correction signal (COR), depending on a quality indicator, which gives the stability of the timing signal and is part of the digital information signal (STM), the oscillator only being tuned at times when the quality indicator guarantees a high frequency accuracy of the pulse train frequency.

8. Method as claimed in Claim 7, **characterized in that** the digital information signal (STM) is an information signal of the synchronous digital hierarchy, that the quality indicator is formed from bits 5 to 8 of the S1 byte, which is contained in the SOH section of the frame of the information signal (STM), and that the oscillator (OSC) is only tuned at times when the quality indicator consists of the bit sequence 0010.

9. Method as claimed in Claim 7, **characterized in that** the digital information signal (STM) is an information signal of the plesiochronous digital hierarchy, that one of the bits Sₐ₄ to Sₐ₈ in the superframe structure of the information signal (STM) is used as quality indicator, and that the oscillator (OSC) is only tuned at times when the quality indicator consists of the bit sequence 0010.

## Revendications

1. Station de base (BTS) avec un oscillateur réglable pour la génération d'une fréquence porteuse (CAR) et avec une installation (VA) pour le réglage de l'oscillateur (OSC), **caractérisée en ce que** l'installation (VA) pour le réglage de l'oscillateur (OSC) comprend les unités fonctionnelles suivantes :
- un dispositif de dérive de cadence (TA) pour la génération d'une cadence (CLK) dotée d'une fréquence de répétition des impulsions à partir d'un signal numérique d'information (STM),
- avec un comparateur de fréquences (FC) pour générer un signal correcteur (COR), qui dépend d'une différence entre la fréquence (OF) de l'oscillateur (OSC) et la fréquence de répétition des impulsions de la cadence (CLK), avec lequel l'oscillateur (OSC) peut être réglé, et
- avec un dispositif de commande (LOGIC) pour le réglage de l'oscillateur (OSC) avec le signal correcteur (COR) en relation étroite avec un indicateur de qualité qui indique la stabilité de la cadence et fait partie du signal numérique d'information (STM),
moyennant quoi l'oscillateur n*est réglé qu'aux moments où l'indicateur de qualité garantit une haute précision de fréquence de la fréquence de répétition des impulsions.

2. Station de base (BTS) selon la revendication 1, **caractérisée en ce que** le dispositif de commande (LOGIC) est prévu pour l'analyse de l'indicateur de qualité qui est compris dans la trame du signal d'information reçu.

3. Station de base (BTS) selon la revendication 1, **caractérisée en ce que** pour le signal d'information, il s'agit d'un signal d'information de modulation par impulsions codées (PCM) qui est reçu d'un centre de commutation mobile du réseau de transmission d'informations.

4. Station de base (BTS) selon la revendication 1, **caractérisée en ce que** le dispositif de dérive de la cadence (TA) pour générer une cadence à partir d'un signal d'information (STM) de la hiérarchie numérique synchrone sert à ce que le dispositif de commande (LOGIC) pour le réglage de l'oscillateur (OSC) utilise comme indicateur de qualité les bits 5 à 8 de l'octet S1, qui est contenu dans la section SOH de la trame du signal d'information (STM), et **en ce que** l'oscillateur (OSC) n'est réglable que lorsque l'indicateur de qualité est formé de la suite de bits 0010.

5. Station de base selon la revendication 1, **caractérisée en ce que** le dispositif de dérive de la cadence (TA) pour générer une cadence à partir d'un signal d'information (STM) de la hiérarchie numérique plésiochrone sert à ce que le dispositif de commande (LOGIC) pour le réglage de l'oscillateur (OSC) utilise comme indicateur de qualité un des bits S₀₄ à S₀₈ dans la structure de supertrame du signal d'information (STM) et **en ce que** l'oscillateur (OSC) n'est réglable que lorsque l'indicateur de qualité est formé de la suite de bits 0010.

6. Station de base selon la revendication 1, **caractérisée en ce que** le dispositif de dérive de cadence (TA) contient un passe-bas qui réprime avec une constante de temps qui peut durer plusieurs heures les variations de phase et de fréquence de la cadence (CLK) du signal numérique d'information (STM).

7. Procédé pour le réglage d'un oscillateur (OSC) réglable conçu pour générer une fréquence porteuse (CAR) d'une station de base (BTS), **caractérisé en ce qu'**il contient les étapes suivantes :
- génération d'une cadence (CLK) avec une fréquence de répétition d'impulsions à partir d'un signal numérique d'information (STM),
- génération d'un signal correcteur (COR) qui dépend d'une différence entre la fréquence (OF) de l'oscillateur (OSC) et la fréquence de répétition d'impulsions de la cadence (CLK),
- réglage de l'oscillateur (OSC) avec le signal correcteur (COR) en relation étroite avec un indicateur de qualité qui indique la stabilité de la cadence et fait partie du signal numérique d'information (STM),
moyennant quoi l'oscillateur n'est réglé qu'aux moments où l'indicateur de qualité garantit une haute précision de fréquence de la fréquence de répétition des impulsions.

8. Procédé selon la revendication 7, **caractérisé en ce que** pour le signal numérique d'information (STM), il s'agit d'un signal d'information de la hiérarchie numérique synchrone, **en ce que** l'indicateur de qualité se compose des bits 5 à 8 de l'octet S1 qui est contenu dans la section SOH de la trame du signal d'information (STM), et en ce le réglage de l'oscillateur (OSC) n'a lieu qu'aux moments où l'indicateur de qualité est formé de la suite de bits 0010.

9. Procédé selon la revendication 7, **caractérisé en ce que** pour le signal numérique d'information (STM), il s'agit d'un signal d'information de la hiérarchie numérique plésiochrone, **en ce que** comme indicateur de qualité on utilise un des bits Sₐ₄ à Sₐ₈ dans la structure de supertrame du signal d'information (STM), et **en ce que** le réglage de l'oscillateur (OSC) n'a lieu qu'aux moments où l'indicateur de qualité est formé de la suite de bits 0010.
